# EUROPÄISCHE PATENTANMELDUNG

(11) **EP 3 373 170 A1**
(43) Veröffentlichungstag der Anmeldung: **12.09.2018**
(21) Anmeldenummer: 18168102.4
(22) Anmeldetag: 30.07.2003
(51) Int. Cl.: G06F 17/50

(54) **VORRICHTUNG ZUR EMULATION VON ENTWÜRFEN FÜR INTEGRIERTE SCHALTKREISE**

(62) Teilanmeldung aus: 03016640.9
(71) Anmelder: Synopsys, Inc., Mountain View, CA 94043 (US)
(72) Erfinder: Mauersberger, Heiko, 99330 Crawinkel (DE)
(74) Vertreter: Schlimme, Wolfram

(57) **Zusammenfassung**

Eine Vorrichtung zur Emulation von Entwürfen für integrierte Schaltkreise ist versehen mit zumindest einer Aufnahmeeinrichtung (1, 2, 3, 4, 5, 6) ausgebildet zur Aufnahme von einer Mehrzahl von programmierbaren Logikschaltkreisen (11, 12, 13; 21, 22, 23) mit Anschlusskontakten sowie einer elektrischen Verbindungsstruktur (14; 24), die BUS-Leitungen (111, 112, 121, 122, 131, 132; 211, 212, 221, 222, 231, 232) aufweist, die jeweils eine Vielzahl von Kanälen (1 ...k) umfassen, wobei jeder programmierbare Logikschaltkreis (11, 12, 13; 21, 22, 23) der Mehrzahl von programmierbaren Logikschaltkreisen an zumindest eine BUS-Leitung der BUS-Leitungen (111, 112, 121, 122, 131, 132; 211, 212, 221, 222, 231, 232) angeschlossen ist, wenn er mit der Aufnahmeeinrichtung verbunden ist, wobei die elektrische Verbindungsstruktur (14; 24) so ausgebildet ist, dass die Mehrzahl von programmierbaren Logikschaltkreisen unabhängig miteinander verbindbar sind, wobei zumindest ein Teil der Anschlusskontakte eines jeden programmierbaren Logikschaltkreises (11, 12, 13; 21, 22, 23) unabhängig belegbar ist, wobei zumindest ein Teil der mit den programmierbaren Logikschaltkreisen (11, 12, 13; 21, 22, 23) verbundenen BUS-Leitungen (111, 112, 121, 122, 131, 132; 211, 212, 221, 222, 231, 232) mittels eines Schalters (S₁...Sₖ) wahlweise miteinander elektrisch verbindbar ist, wobei zumindest ein Kanal (1...k) einer BUS-Leitung (111, 112, 121, 122, 131, 132; 211, 212, 221, 222, 231, 232) mit einem Kanal (1...k) von zumindest einer anderen BUS-Leitung (111, 112, 121, 122, 131, 132; 211, 212, 221, 222, 231, 232) mittels des Schalters (S₁...Sₖ) elektrisch verbindbar ist, wobei mehrere Aufnahmeeinrichtungen (1, 2; 3, 4; 5, 6) vorgesehen und über Verbindungseinrichtungen (7A, 7B, 7C; 9A, 9B) miteinander verbindbar sind, wobei die Verbindungseinrichtungen (7A, 7B, 7C; 9A, 9B) schaltbare BUS-Leitungen aufweisen.

## Beschreibung

Die Erfindung betrifft eine Vorrichtung zur Emulation von Entwürfen für integrierte Schaltkreise gemäß dem Oberbegriff des Patentanspruchs 1.

Eine gängige Methode zur Verifikation von Entwürfen für integrierte Schaltkreise, sogenannten Chipdesigns, ist deren Abbildung mit einer programmierbaren Hardware. Eine solche programmierbare Hardware ist häufig aus programmierbaren Logikschaltkreisen, sogenannten FPGA-Schaltkreisen (FPGA: field programmable gate array) aufgebaut. Den Vorgang der Verifikation auf einer solchen Hardware bezeichnet man als "Emulation" oder "Rapid Prototyping".

Da es aufgrund der Größe und Komplexität eines Entwurfs nicht immer möglich ist, den gesamten Entwurf in nur einem einzigen programmierbaren Logikschaltkreis abzubilden, wird eine programmierbare Hardware verwendet, die aus mehreren programmierbaren Logikschaltkreisen besteht. Ein dabei auftretendes Problem ist die geeignete Verdrahtung der Logikschaltkreise untereinander. Werden lediglich zwei Logikschaltkreise miteinander verbunden, so lässt sich diese Verbindung einfach als Eins-zu-eins-Verdrahtung aufbauen. Sollen jedoch drei Logikschaltkreise miteinander verbunden werden, so können diese entweder in einer Sternstruktur, in einer Dreiecksstruktur oder in einer Mischform miteinander verschaltet werden. Dabei treten bereits eine Vielzahl von Leitungskreuzungen auf, die in optimaler Weise auf der die Logikschaltkreise aufnehmenden Leiterplatte untergebracht werden müssen. Je mehr programmierbare Logikschaltkreise verwendet werden müssen, um ein Chipdesign zu verifizieren, um so komplizierter werden die Strukturen. Werden diese Strukturen nun auf einer speziell für den Anwendungsfall erstellten Leiterplatte abgebildet, so ergeben sich im Wesentlichen zwei Nachteile:
- die Struktur muss beim Schaltungsentwurf und beim Layout der Leiterplatte bereits feststehen. Da sich aber das zu verifizierende Chipdesign zu diesem Zeitpunkt zumeist noch in Entwicklung befindet, ist es äußerst schwierig, im Voraus ein Layout der Leiterplatte zu erstellen. Weiterhin treten dann Probleme auf, wenn sich aufgrund von Änderungen in der Entwicklung die benötigte Struktur ändert, so dass dann die Leiterplatte umgebaut werden müsste;
- eine für einen speziellen Anwendungsfall hergestellte Leiterplatte kann in der Regel nicht für zukünftige Anwendungsfälle verwendet werden, da dort wieder andere Anforderungen an die Verbindungsstruktur bestehen.

Aus der EP 0 651 343 sind ein Verfahren zur Verwendung einer elektronisch wiederkonfigurierbaren Gatterfeldlogik und ein dadurch hergestelltes Gerät bekannt, bei welchem die Logik-Schaltkreise über eine Kreuzschienen-Schaltanordnung (Anordnung aus sogenannten crossbar chips) miteinander verbunden sind.

Diese Lösung mittels Kreuzschienenschaltern ist jedoch nicht sehr vorteilhaft, da Kreuzschienenschalter Spezialschaltkreise sind, die ein begrenztes Einsatzgebiet besitzen und deren Marktverfügbarkeit nicht immer garantiert ist. Darüber hinaus wird das entsprechende Gehäuse des Kreuschienenschalter-Chips und dessen Aufbau um so komplexer, je größer die Anzahl der zu schaltenden Leitungen wird. Dementsprechend ist auch das Leiterplattendesign für derartige Chips äußerst aufwendig. Durch die hohe Komplexität dieser Kreuzschienenschalter-Chips, in denen jedes Signal mit jedem Signal verbunden werden kann, werden nur verhältnismäßig lange Durchlaufzeiten der Signale erreicht. Dieses hat im vorliegenden Anwendungsfall unmittelbaren Einfluss auf die Verifikationsgeschwindigkeit und auf die Verifikationszeit, indem die Verifikationsgeschwindigkeit sinkt und die Verifikationszeit ansteigt. Ziel ist es jedoch bei der Emulation von Entwürfen für integrierte Schaltkreise, den Chipentwurf mit möglichst hoher Geschwindigkeit zu verifizieren und damit die Verifikationszeit zu minimieren.

Es ist daher die Aufgabe der vorliegenden Erfindung, eine Vorrichtung zur Emulation von Entwürfen für integrierte Schaltkreise gemäß dem Oberbegriff des Patentanspruchs 1 derart auszugestalten, dass bei hoher Flexibilität der Verbindungsstruktur eine hohe Verifikationsgeschwindigkeit ermöglicht wird und damit die Verifikationszeit minimiert werden kann.

Diese Aufgabe wird durch die im Patentanspruch 1 angegebenen Merkmale gelöst.

Bei der erfindungsgemäßen Ausgestaltung der Emulationsvorrichtung wird eine den programmierbaren Logikschaltkreisen, insbesondere den FPGAs, innewohnende Eigenschaft ausgenutzt, nämlich jene, dass die Signale aus dem Logikschaltkreis an beliebige Anschlusskontakte des Logikschaltkreises geroutet werden können. Bei herkömmlichen integrierten Schaltkreisen (zum Beispiel Prozessoren) sind die Anschlusskontakte inneren Strukturen des Schaltkreises hingegen fest zugeordnet. Beim Erfindungsgegenstand wird die flexible Eigenschaft der beliebigen Kontaktierung der Anschlusskontakte mit inneren Strukturen des Logikschaltkreises ausgenutzt, um in Verbindung mit den wahlweise miteinander verbindbaren BUS-Leitungen genau jene Kombinationsmöglichkeiten herzustellen, die für den Aufbau des Entwurfs des integrierten Schaltkreises erforderlich sind. Es müssen also nicht, wie im mit Kreuzschienen-Schaltkreisen arbeitenden Stand der Technik, alle grundsätzlich möglichen Kombinationsmöglichkeiten vorgesehen werden.

Vorzugsweise ist eine Mehrzahl von Kanälen einer BUS-Leitung mit einer Mehrzahl von Kanälen einer anderen BUS-Leitung wahlweise elektrisch verbindbar, wobei jeder Kanal der einen BUS-Leitung mit dem zugeordneten Kanal der anderen BUS-Leitung elektrisch verbindbar ist, wobei die einzelnen Kanäle unabhängig voneinander verbindbar sind. Durch diese Ausgestaltung wird die Flexibilität erhöht.

Vorzugsweise sind zwischen zumindest einem Teil der programmierbaren Logikschaltkreise Verbindungs-BUS-Leitungen zur direkten Verbindung der entsprechenden Logikschaltkreise miteinander vorgesehen. Geht man von einem typischen Chipdesign aus, welches auf mehrere Logikschaltkreise (zum Beispiel FPGAs) verteilt wird, so ist die Wahrscheinlichkeit hoch, dass benachbarte Logikschaltkreise mehr Verbindungsleitungen untereinander benötigen, als Logikschaltkreise, die weiter voneinander entfernt sind. Für diese Verbindungsleitungen der benachbarten Logikschaltkreise sind Verbindungs-BUS-Leitungen zur direkten Verbindung vorgesehen. Hierdurch wird die Anzahl der benötigten Schalter reduziert und die Signallaufzeiten werden aufgrund der kurzen direkten Verbindungswege spürbar reduziert.

In einer bevorzugten Weiterbildung sind mehrere Aufnahmeeinrichtungen über Verbindungseinrichtungen miteinander verbindbar, wobei die Verbindungseinrichtungen schaltbare BUS-Leitungen aufweisen. Hierdurch wird es möglich, eine modular aufgebaute Vorrichtung zu schaffen, die durch Verbindung mehrerer Aufnahmeeinrichtungen, die im Wesentlichen identisch aufgebaut sein können, realisiert wird.

Dabei sind vorzugsweise Haupt-Verbindungseinrichtungen vorgesehen, die jeweils zwei Aufnahmeeinrichtungen miteinander verbinden, wobei die Haupt-Verbindungseinrichtung BUS-Leitungen aufweisen, die jeweils einander zugeordnete BUS-Leitungen der beiden Aufnahmeeinrichtungen miteinander verbinden und wobei die BUS-Leitungen einer Haupt-Verbindungseinrichtung derart wahlweise miteinander elektrisch verbindbar sind, dass zumindest ein Kanal einer BUS-Leitung mit einem Kanal von zumindest einer anderen BUS-Leitung elektrisch verbindbar ist. Mit derartigen Haupt-Verbindungseinrichtungen können auf einfache Weise jeweils zwei Aufnahmeeinrichtungen zu einem Aufnahmeeinrichtungspaar miteinander verbunden werden.

Weiter vorteilhaft ist es, wenn Gruppen-Verbindungseinrichtungen vorgesehen sind, die jeweils zwei aus zwei mit einer Haupt-Verbindungseinrichtung verbundenen Aufnahmeeinrichtungen bestehende Aufnahmeeinrichtungspaare miteinander verbinden und wobei eine Gruppen-Verbindungseinrichtung BUS-Leitungen aufweist, die mit den BUS-Leitungen der jeweiligen Aufnahmeeinrichtungspaare verbunden sind und wobei die BUS-Leitungen der Gruppen-Verbindungseinrichtungen jeweils derart schaltbar sind, dass jedem Kanal einer jeden BUS-Leitung der Gruppen-Verbindungseinrichtung ein Schalter zugeordnet ist und dass die jeweiligen Schalter unabhängig voneinander ein- und ausschaltbar sind. Das Vorsehen dieser Gruppen-Verbindungseinrichtungen ermöglicht es, Paare von Aufnahmeeinrichtungen, die jeweils mittels einer Haupt-Verbindungseinrichtung miteinander verbunden sind, nahezu beliebig aneinander zu reihen.

In einer bevorzugten Realisierung der erfindungsgemäßen Vorrichtung weisen die Aufnahmeeinrichtungen, die Haupt-Verbindungseinrichtungen und die Gruppen-Verbindungseinrichtungen Leiterplatten auf, die an ihrer Oberseite und an ihrer Unterseite jeweils mit einer Steckverbinderanordnung versehen sind, die aus mehreren Steckverbindern besteht, welche in derselben Position auf der jeweiligen Leiterplatte angeordnet sind und wobei die nach außen führenden BUS-Leitungen der jeweiligen Leiterplatte sowohl mit oberen als auch mit entsprechenden unteren Steckverbindern der jeweiligen Steckverbinderanordnung in gleicher Weise elektrisch verbunden sind. Diese Ausgestaltung gestattet einen modularen Aufbau der erfindungsgemäßen Vorrichtung, da Aufnahmeeinrichtungen, Haupt-Verbindungseinrichtungen und Gruppen-Verbindungseinrichtungen einfach übereinander angeordnet und zur Kontaktierung zusammengesteckt werden können.

Eine bevorzugte Ausgestaltung dieses modularen Aufbaus zeichnet sich dadurch aus, dass die Leiterplatten übereinander angeordnet und mittels der Steckverbinderanordnungen mechanisch und elektrisch miteinander verbunden sind, wobei jeweils zwei Leiterplatten der Aufnahmeeinrichtungen mittels einer zwischen diesen angeordneten Leiterplatte einer Haupt-Verbindungseinrichtung sandwichartig zu einem Aufnahmeeinrichtungspaar verbunden sind und wobei die Aufnahmeeinrichtungspaare miteinander mittels der Leiterplatten der Gruppen-Verbindungseinrichtungen verbunden sind. Durch diese sandwichartige und modulare Anordnung der Aufnahmeeinrichtungen, Haupt-Verbindungseinrichtungen und Gruppen-Verbindungseinrichtungen entsteht ein kompakter Block als Aufbau einer erfindungsgemäßen Vorrichtung mit extrem kurzen Signalwegen und entsprechend kurzen Signallaufzeiten, wodurch eine hohe Verifikationsgeschwindigkeit erzielt werden kann.

Vorzugsweise ist zwischen einigen der Steckverbinder der jeweiligen Steckverbinderanordnungen ein Abstand vorgesehen, der das Durchströmen von Kühlluft zwischen den Steckverbindern durch das Leiterplatten-Sandwich ermöglicht. Die Kühlluft kann in dieser Anordnung sehr wirksam, beispielsweise nach dem Querstromprinzip, die Leiterplatten umfließen und die dort entstehende Wärme abführen.

Zur Durchführung der flexiblen Verschaltung der Verbindungsstruktur einer Vorrichtung zur Emulation von Entwürfen für integrierte Schaltkreise gemäß der Erfindung wird besonders bevorzugt ein Computerprogramm eingesetzt, welches die folgenden Programmschritte ausführt:
- Überprüfen, ob in dem zu emulierenden Entwurf eines integrierten Schaltkreises Elemente mit einer Platzierungsvorgabe vorgesehen sind;
- falls derartige Elemente vorgesehen sind, Zuordnen eines Einbauplatzes der Aufnahmeeinrichtung für das jeweilige Element;
- Zuordnen eines jeweiligen Einbauplatzes für ein jeweiliges Element ohne Platzierungsvorgabe;
- Überprüfen, ob zwischen den Elementen untereinander und/oder mit externen Erweiterungselementen Signale über vorgegebene Anschlusskontakte auszutauschen sind;
- falls dies der Fall ist, Zuordnen der jeweiligen Anschlusskontakte zueinander über entsprechende Kanäle der BUS-Leitungen;
- Routen der verbleibenden auszutauschenden Signale;
- Berechnen der internen und externen Belegung der Anschlusskontakte der Logikschaltkreise;
- Herstellen der internen Verbindungen zwischen dem zu emulierenden integrierten Schaltkreisentwurf und den zugeordneten Anschlusskontakten eines jeden programmierbaren Logikschaltkreises und
- Herstellen der externen Verbindungen zwischen den Anschlusskontakten der programmierbaren Logikschaltkreise und den zugeordneten Kanälen der BUS-Leitungen.

Ein derartiges Computerprogramm beschleunigt den Vorgang der Schaltungsauflösung und der Verbindung der einzelnen Logikschaltkreise untereinander und steuert die einzelnen Schalter unmittelbar an.

Die Erfindung wird nachfolgend anhand eines Beispiels unter Bezugnahme auf die Zeichnung näher erläutert; in dieser zeigt:
- **Fig. 1**: eine schematische Darstellung einer ersten Ausführungsform einer erfindungsgemäßen Vorrichtung;
- **Fig. 2**: eine vergrößerte schematische Darstellung einer schaltbaren BUS-Leitung gemäß der vorliegenden Erfindung;
- **Fig. 3**: eine schematische Darstellung einer weiteren Ausführungsform der vorliegenden Erfindung mit zwei ein Aufnahmeeinrichtungspaar bildenden Aufnahmeeinrichtungen;
- **Fig. 4**: eine schematische Darstellung noch einer weiteren Ausführungsform der vorliegenden Erfindung mit drei Aufnahmeeinrichtungspaaren;
- **Fig. 5**: einen schematischen Grundriss der Steckverbinderanordnung, wie sie auf einer Aufnahmeeinrichtung, einer Haupt-Verbindungseinrichtung und einer Gruppen-Verbindungseinrichtung vorgesehen ist;
- **Fig. 6**: eine Seitenansicht eines Leiterplatten-Sandwiches einer erfindungsgemäßen Vorrichtung; und
- **Fig. 7**: ein Flussdiagramm eines Computerprogramms zur flexiblen Verschaltung der Verbindungsstruktur einer erfindungsgemäßen Vorrichtung.

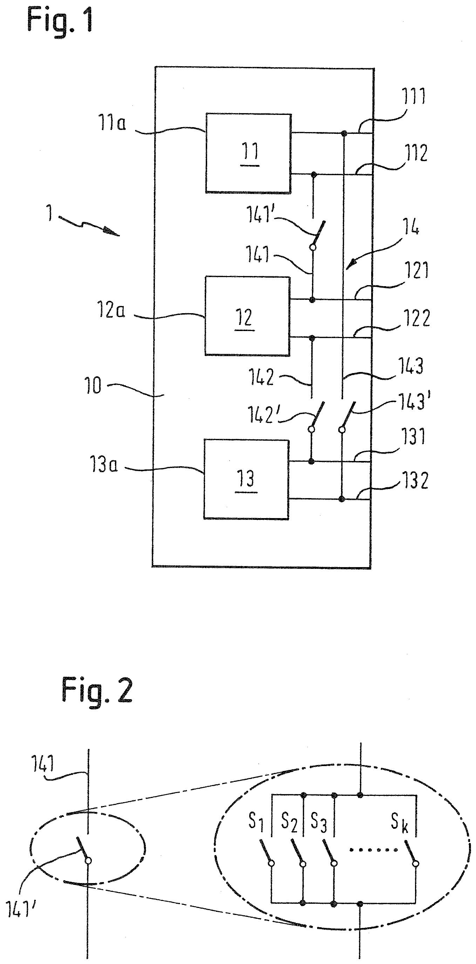

In Fig. 1 ist eine Aufnahmeeinrichtung 1 gezeigt, die eine Leiterplatte 10 aufweist, auf der drei Einbauplätze 11a, 12a, 13a für programmierbare Logikschaltkreise 11, 12, 13 und eine in der Fig. 1 nur schematisch dargestellte elektrische Verbindungsstruktur 14 vorgesehen sind.

Jeder der Einbauplätze 11a, 12a, 13a für die entsprechenden programmierbaren Logikschaltkreise 11, 12, 13 ist mit zwei BUS-Leitungen 111, 112; 121, 122; 131, 132 verbunden, wobei jede der BUS-Leitungen mit einer Mehrzahl von (nicht gezeigten) Anschlusskontakten des jeweiligen Einbauplatzes 11a, 12a, 13a verbunden ist. Das Vorsehen von jeweils zwei BUS-Leitungen pro Einbauplatz ist lediglich beispielhaft gezeigt; es können pro Einbauplatz auch nur eine BUS-Leitung oder mehr als zwei BUS-Leitungen vorgesehen sein.

Die BUS-Leitungen 111, 112; 121, 122; 131, 132 sind durch BUS-Verbindungsleitungen 141, 142, 143 miteinander verbunden, wobei in jeder BUS-Verbindungsleitung eine weiter unten unter Bezugnahme auf Fig. 2 näher erläuterte BUS-Schaltvorrichtung 141'; 142'; 143' vorgesehen ist. Im Einzelnen verbindet die schaltbare BUS-Verbindungsleitung 141 die zweite BUS-Leitung 112 des ersten Einbauplatzes 11 a mit der ersten BUS-Leitung 121 des zweiten Einbauplatzes 12a. Die BUS-Verbindungsleitung 142 verbindet die zweite BUS-Leitung 122 des zweiten Einbauplatzes 12a mit der ersten BUS-Leitung 131 des dritten Einbauplatzes 13a. Die BUS-Verbindungsleitung 143 verbindet die zweite BUS-Leitung 132 des dritten Einbauplatzes 13a mit der ersten BUS-Leitung 111 des ersten Einbauplatzes 11a.

In Fig. 2 ist die BUS-Schaltvorrichtung 141' der ersten BUS-Verbindungsleitung 141 schematisch in einer Vergrößerung dargestellt. Man kann erkennen, dass die BUS-Schaltvorrichtung 141' aus einer Vielzahl von Schaltern S₁ bis Sₖ besteht, die jeweils einen der Kanäle 1 bis k der BUS-Verbindungsleitung 141 schalten. Die Schalter S₁ bis Sₖ können dabei unabhängig voneinander ein- und ausgeschaltet werden. Die BUS-Schalteranordnung 141' kann so ausgebildet sein, dass sie alle Kanäle der BUS-Verbindungsleitung 141 oder nur einen Teil davon schaltet. Die anderen BUS-Schaltvorrichtungen 142', 143' sind auf dieselbe Weise ausgebildet wie die erste BUS-Schaltvorrichtungen 141'.

Durch die Schaltbarkeit der einzelnen Kanäle der BUS-Verbindungsleitungen 141, 142, 143 und die freie Belegbarkeit der Anschlusskontakte eines jeden programmierbaren Logikschaltkreises 11, 12, 13 lässt sich jede gewünschte Verbindung in einer Ringstruktur zwischen den Logikschaltkreisen 11, 12, 13 herstellen.

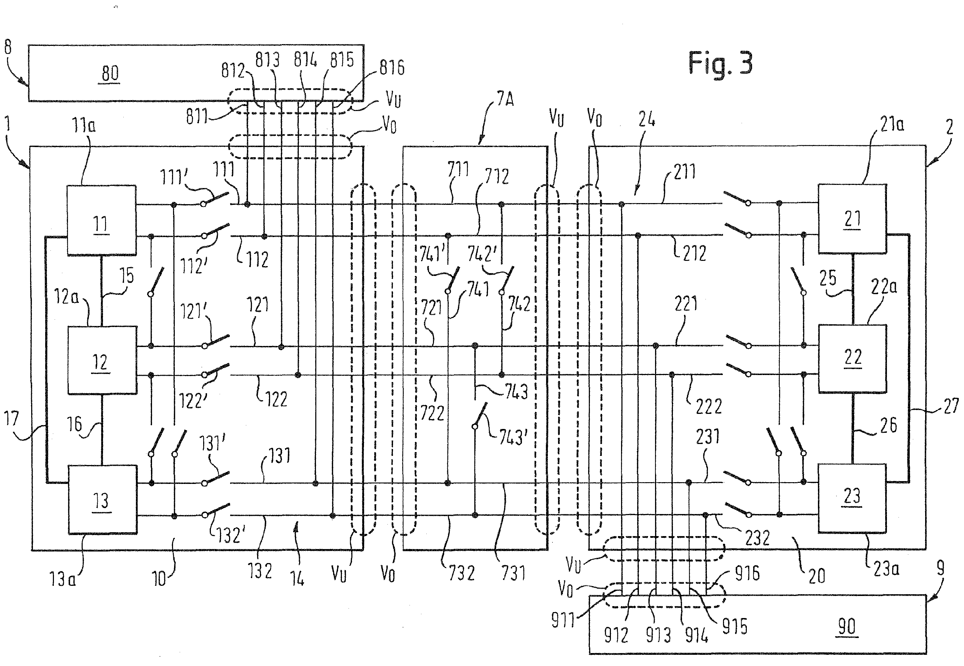

In Fig. 3 ist eine Paarung zweier Aufnahmeeinrichtungen 1, 2 dargestellt, die über eine Haupt-Verbindungseinrichtung 7A elektrisch miteinander verbunden sind. In der Figur sind die Aufnahmeeinrichtungen 1, 2 sowie die Haupt-Verbindungseinrichtung 7A zum besseren Verständnis der elektrischen Verbindungen in der Ebene nebeneinander dargestellt. In der Praxis sind sie jedoch übereinander angeordnet, wie es weiter unten noch beschrieben wird. Die Aufnahmeeinrichtung 1 entspricht im Wesentlichen der Aufnahmeeinrichtung 1 aus Fig. 1, enthält jedoch zusätzlich auf der Leiterplatte 10 direkte Verbindungs-BUS-Leitungen 15, 16, 17, wobei die Verbindungs-BUS-Leitung 15 einen Teil der Anschlusskontakte des ersten Einbauplatzes 11 a mit einem Teil der Anschlusskontakte des zweiten Einbauplatzes 12a verbindet. Die zweite Verbindungs-BUS-Leitung 16 verbindet einen Teil der Anschlusskontakte des zweiten Einbauplatzes 12a mit einem Teil der Anschlusskontakte des dritten Einbauplatzes 13a und die dritte Verbindungs-BUS-Leitung 17 verbindet einen Teil der Anschlusskontakte des dritten Einbauplatzes 13a mit einem Teil der Anschlusskontakte des ersten Einbauplatzes 11a. Über diese direkten Verbindungs-BUS-Leitungen werden Signale geroutet, die zwischen den einzelnen programmierbaren Logikschaltkreisen 11, 12, 13 direkt ausgetauscht werden, ohne dass es dazu einer flexiblen Programmierung des ganzen Routings bedarf.

Die Leiterplatte 10 der ersten Aufnahmeeinrichtung 1 weist außerdem gegenüber der in Fig. 1 nur schematisch dargestellten Schaltung BUS-Schaltvorrichtungen 111', 112'; 121', 122'; 131', 132' auf, die jeweils in den zugeordneten BUS-Leitungen 111, 112; 121, 122; 131, 132 auf der vom zugehörigen Einbauplatz 11 a; 12a; 13a abgewandten Seite der jeweiligen BUS-Verbindungsleitung 141; 142; 143 vorgesehen sind. Diese BUS-Schaltvorrichtungen 111', 112'; 121', 122'; 131', 132' sind genauso aufgebaut wie die in Fig. 2 dargestellte BUS-Schaltvorrichtung. Die BUS-Leitungen 111, 112, 121, 122, 131, 132 sind auf der von den Schaltvorrichtungen 111', 112'; 121', 122'; 131', 132' bezüglich des zugeordneten Einbauplatzes 11a; 12a; 13a abgewandten Seite mit auf der Oberseite der Leiterplatte 10 angeordneten, in Fig. 3 nur schematisch gezeigten, Steckverbindern einer oberen Steckverbinderanordnung V_{O} und mit an der Unterseite der Leiterplatte 10 angeordneten, in Fig. 3 ebenfalls nur schematisch dargestellten, Steckverbindern einer unteren Steckverbinderanordnung V_{U} elektrisch verbunden. Jedem Kanal einer BUS-Leitung sind dabei ein Kontakt der oberen Steckverbinderanordnung V_{O} und der diesem entsprechende Kontakt der unteren Steckverbinderanordnung V_{U} zugeordnet.

Die Aufnahmeeinrichtung 2 besteht im Beispiel der Fig. 3 aus einer Leiterplatte 20, die in dieser schematischen Schaltungsansicht spiegelverkehrt zur Leiterplatte 10 der Aufnahmeeinrichtung 1 dargestellt ist, in der praktischen Ausführung sind die Leiterplatten 10 und 20 jedoch im Wesentlichen identisch aufgebaut. Die Aufnahmeeinrichtung 2 weist ebenfalls drei programmierbare Logikschaltkreise 21, 22, 23 auf, die über eine Verbindungsstruktur 24 miteinander in der gleichen Weise verbunden sind wie dies in der Aufnahmeeinrichtung 1 der Fall ist. Auch die direkten Verbindungs-BUS-Leitungen 25, 26, 27 sind analog vorgesehen. Die von den Einbauplätzen 21 a, 22a, 23a der Leiterplatte 20 ausgehenden BUS-Leitungen 211, 212, 221, 222, 231, 232 entsprechen den BUS-Leitungen der Fig. 1 mit einem um 100 niedrigeren Bezugszeichen. Auch die entsprechenden BUS-Verbindungsleitungen sind wie in der Aufnahmeeinrichtung 1 vorgesehen und mit entsprechenden BUS-Schalteinrichtungen versehen. Die Aufnahmeeinrichtung 2 entspricht somit im Aufbau der Aufnahmeeinrichtung 1.

Die zwischen den Aufnahmeeinrichtungen 1 und 2 angeordnete Haupt-Verbindungseinrichtung 7A weist entsprechende BUS-Leitungen 711, 712; 721, 722; 731, 732 auf, die über jeweilige Steckverbinder einer oberen Steckverbinderanordnung V_{O} sowie einer unteren Steckverbinderanordnung V_{U} die jeweiligen BUS-Leitungen der Aufnahmeeinrichtungen 1 und 2 miteinander verbinden. Dabei verbindet die erste BUS-Leitung 711 die BUS-Leitung 111 der Aufnahmeeinrichtung 1 mit der BUS-Leitung 211 der Aufnahmeeinrichtung 2. Die zweite BUS-Leitung 712 verbindet die BUS-Leitung 112 der Aufnahmeeinrichtung 1 mit der BUS-Leitung 212 der Aufnahmeeinrichtung 2. Die dritte BUS-Leitung 721 verbindet die BUS-Leitung 121 der Aufnahmeeinrichtung 1 mit der BUS-Leitung 221 der Aufnahmeeinrichtung 2. Die vierte BUS-Leitung 722 verbindet die BUS-Leitung 122 der Aufnahmeeinrichtung 1 mit der BUS-Leitung 222 der Aufnahmeeinrichtung 2. Die fünfte BUS-Leitung 731 verbindet die BUS-Leitung 131 der Aufnahmeeinrichtung 1 mit der BUS-Leitung 231 der Aufnahmeeinrichtung 2. Die sechste BUS-Leitung 732 verbindet die BUS-Leitung 132 der Aufnahmeeinrichtung 1 mit der BUS-Leitung 232 der Aufnahmeeinrichtung 2.

Auch die Haupt-Verbindungseinrichtung 7A ist mit schaltbaren BUS-Verbindungsleitungen 741, 742, 743 versehen, wobei die BUS-Verbindungsleitung 741 die zweite BUS-Leitung 712 mit der fünften BUS-Leitung 731 verbindet. Die BUS-Verbindungsleitung 742 verbindet die erste BUS-Leitung 711 mit der vierten BUS-Leitung 722 und die BUS-Verbindungsleitung 743 verbindet die dritte BUS-Leitung 721 mit der sechsten BUS-Leitung 732.

Jede der BUS-Verbindungsleitungen 741, 742, 743 weist eine BUS-Schaltvorrichtung 741', 742', 743' auf, die jeweils entsprechend der in Fig. 2 gezeigten BUS-Schaltvorrichtung aufgebaut ist.

Die BUS-Schaltvorrichtungen in der Haupt-Verbindungseinrichtung 7A ermöglichen in Zusammenhang mit den BUS-Schaltvorrichtungen der Aufnahmeeinrichtungen 1 und 2 ein beliebiges Verschalten der an die einzelnen BUS-Kanäle angelegten Anschlusskontakte der jeweiligen Einbauplätze 11a, 12a, 13a, 21 a, 22a, 23a für die programmierbaren Logikschaltkreise 11, 12, 13, 21, 22, 23 sowohl in einer Ringstruktur, als auch in einer Sternstruktur, als auch in einer gemischten Struktur.

Wird die Haupt-Verbindungseinrichtung 7A nur mit einer Aufnahmeeinrichtung 1; 2 verwendet, so wird zusätzlich zu der in Fig. 1 gezeigten Möglichkeit der Schaltung einer Ringstruktur auch die Schaltung einer Sternstruktur oder einer aus diesen beiden gemischten Hybridstruktur möglich.

Die Fig. 3 zeigt weiterhin eine Erweiterungseinrichtung 8, die über Steckverbinder einer unteren Steckverbinderanordnung V_{U} mit Steckverbindern der oberen Steckverbinderanordnung V_{O} der Leiterplatte 10 der Aufnahmeeinrichtung 1 verbunden ist, so dass die BUS-Leitungen 111, 112, 121, 122, 131, 132 der ersten Aufnahmeeinrichtung 1 mit jeweiligen BUS-Leitungen 811, 812, 813, 814, 815, 816 der Erweiterungseinrichtung 8 verbunden sind. Die Erweiterungseinrichtung 8 kann beispielsweise eine Leiterplatte 80 aufweisen, auf der elektronische Bausteine wie Prozessoren, Speicher oder andere integrierte Schaltkreise vorgesehen sind, die mit dem programmierbaren Logikschaltkreisen des zu emulierenden Entwurfs eines integrierten Schaltkreises zusammenwirken.

Die Aufnahmeeinrichtung 2, deren Steckverbinder der oberen Steckverbinderanordnung V_{O} mit den Steckverbindern der unteren Steckverbinderanordnung V_{U} der Leiterplatte 70 der Haupt-Verbindungseinrichtung 7A elektrisch verbunden sind, ist mit den Steckverbindern ihrer unteren Steckverbinderanordnung V_{U} mit einer schematisch dargestellten benachbarten Platine 90 elektrisch verbunden, die zu einer weiteren Erweiterungseinrichtung 9 oder auch zu einer nachfolgend beschriebenen Gruppen-Verbindungseinrichtung gehören kann. Die BUS-Leitungen 911, 912, 913, 914, 915, 916 der Leiterplatte 90 sind dabei in entsprechender Weise mit den BUS-Leitungen 211, 212, 221, 222, 231, 232 der zweiten Aufnahmeeinrichtung 2 elektrisch verbunden.

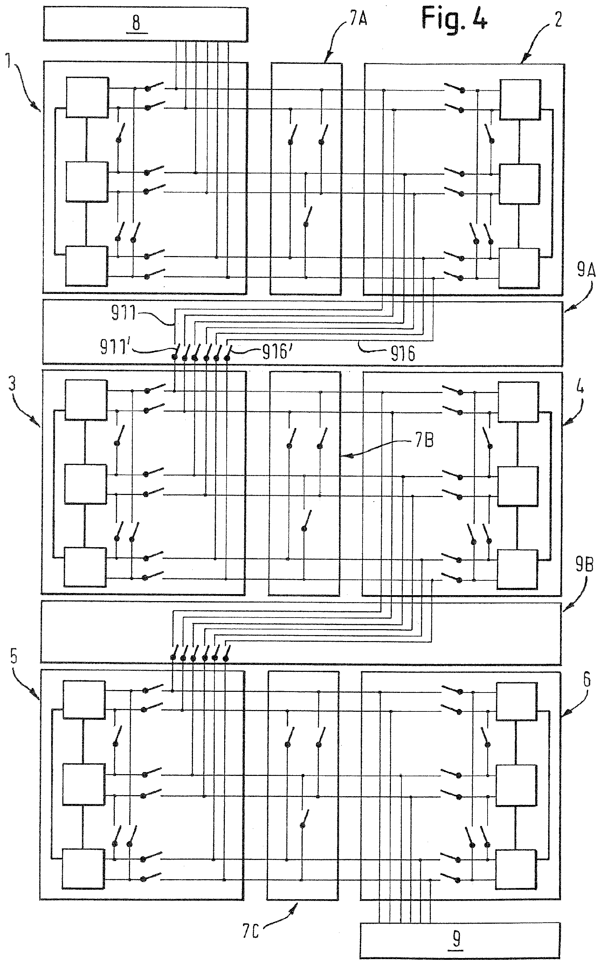

In Fig. 4 sind jeweils drei Aufnahmeeinrichtungspaare 1, 2; 3, 4; 5, 6 mittels Gruppen-Verbindungseinrichtungen 9A, 9B zu einem Block von sechs Aufnahmeeinrichtungen für insgesamt 18 programmierbare Logikschaltkreise zusammengeschlossen. Die Aufnahmeeinrichtungspaare 3, 4 und 5, 6 sind in der gleichen Weise aufgebaut wie das in Bezug auf Fig. 3 beschriebene Aufnahmeeinrichtungspaar 1, 3 und bestehen jeweils aus zwei Aufnahmeeinrichtungen 3, 4 und 5, 6, die jeweils über Haupt-Verbindungseinrichtungen 7B beziehungsweise 7C miteinander verbunden sind. In der Fig. 4 sind die Aufnahmeeinrichtungspaare sowie die Gruppen-Verbindungseinrichtungen 9A, 9B zum besseren Verständnis der elektrischen Verbindung in der Ebene untereinander dargestellt. In der Praxis sind sie jedoch flächig übereinander angeordnet, wie es weiter unten noch beschrieben wird.

Die Gruppen-Verbindungseinrichtungen 9A und 9B sind identisch aufgebaut und sind wie die Erweiterungsleiterplatte 9 in Fig. 3 an die benachbarte Aufnahmeeinrichtung 2, 4 beziehungsweise 4, 6 angeschlossen, wie dies in Bezug auf die Aufnahmeeinrichtung 2 im Zusammenhang mit der Fig. 3 beschrieben worden ist und in der Fig. 4 in Bezug auf die Aufnahmeeinrichtungen 4 und 6 dargestellt ist. Jede der Gruppen-Verbindungseinrichtungen 9A, 9B weist somit BUS-Leitungen 911, 912, 913, 914, 915 und 916 auf, die mit den entsprechenden BUS-Leitungen der benachbarten Aufnahmeeinrichtungen 2, 4 beziehungsweise 4, 6 in der bereits beschriebenen Weise mittels entsprechender Steckverbinder von oberen und unteren Steckverbinderanordnungen elektrisch verbunden sind. In jeder der BUS-Leitungen 911, 912, 913, 914, 915, 916 ist eine BUS-Schaltvorrichtung 911', bis 916' vorgesehen, die der im Zusammenhang mit der Fig. 2 beschriebenen Schaltvorrichtung entspricht.

Die in Fig. 4 dargestellte Verkoppelung der Aufnahmeeinrichtungen 1, 2, 3, 4, 5, 6 mittels der Haupt-Verbindungseinrichtungen 7A, 7B, 7C und der Gruppen-Verbindungseinrichtungen 9A und 9B ermöglicht es, in Verbindung mit der flexiblen Belegung der Anschlusskontakte eines jeden programmierbaren Logikschaltkreises, dass durch geeignete Wahl der jeweiligen Schaltereinstellungen eine beliebige Verschaltung der einzelnen Logik-Schaltkreise vorgenommen werden kann.

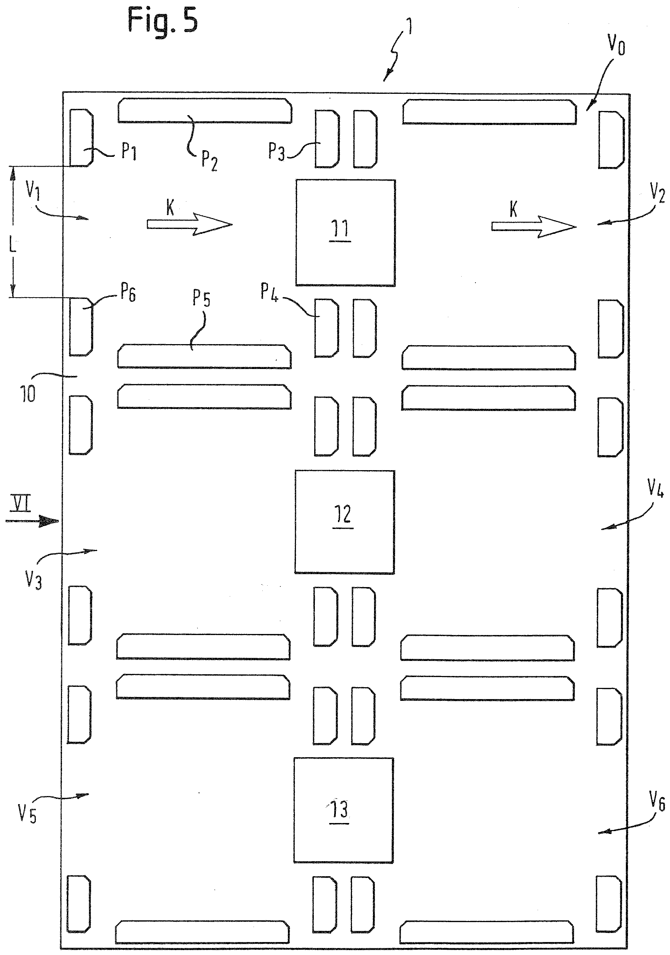

In Fig. 5 ist der schematische Grundriss einer Leiterplatte 10 der in Fig. 1 dargestellten Aufnahmeeinrichtung 1 gezeigt. Die einzelnen als Leiterbahnen ausgebildeten Kanäle der jeweiligen BUS-Leitungen sind nicht dargestellt, um die Figur nicht unübersichtlich erscheinen zu lassen. Bei dieser Draufsicht auf die Leiterplatte 10 sind die programmierbaren Logikschaltkreise 11, 12, 13 sowie die oberen Steckverbinderanordnungen V_{O} nur schematisch dargestellt. Die obere Steckverbinderanordnung V_{O} umfasst eine Vielzahl von Steckverbindern, die in sechs Gruppen V₁, V₂, V₃, V₄, v₅, V₆ zu je sechs im Wesentlichen quadratisch angeordneten Steckverbindern P₁, P₂, P₃, P₄, P₅, P₆ angeordnet sind. Jede der Steckverbindergruppen V₁, V₂, V₃, V₄, V₅, V₆ ist einer der BUS-Leitungen 111, 112, 121, 122, 131, 132 zugeordnet und jeder der BUS-Kanäle ist mit einem der Kontakte der Steckverbinder P₁, P₂, P₃, P₄, P₅, P₆ verbunden. Auf die gleiche Weise, wie dies vorstehend unter Bezugnahme auf die Steckverbindergruppe V₁ für die BUS-Leitung 111 beschrieben worden ist, sind auch die SteckverbinderGruppen V₂, V₃, V₄, V₅ und V₆ ausgebildet.

In Fig. 5 ist auch zu erkennen, dass zwischen den in Längsrichtung der Leiterplatte 10 angeordneten Steckverbindern P₁ und P₆ ein Abstand L freigehalten ist, durch den Kühlluft zu dem zwischen den Steckverbindern P₃ und P₄ angeordneten programmierbaren Logikschaltkreis 11 hin und an diesem seitlich und oben vorbei strömen und an der gegenüber gelegenen Seite durch eine entsprechende Öffnung L' von der Länge L wieder austreten kann. Der Verlauf der KühlluftStrömung ist durch Pfeile K schematisch dargestellt.

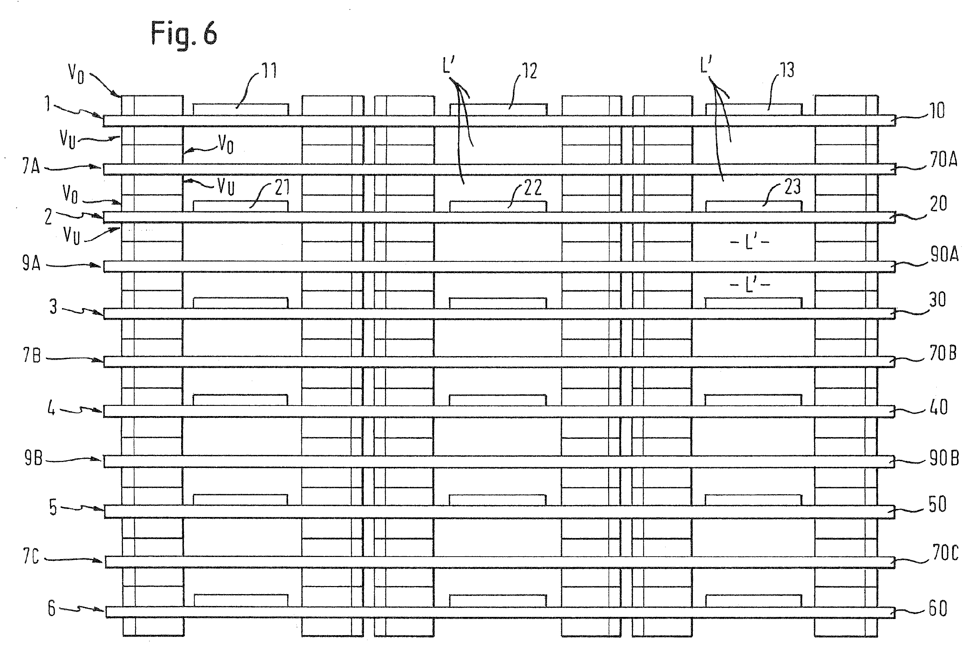

Die Fig. 6 zeigt eine Seitenansicht eines Stapels aus Leiterplatten von Aufnahmeeinrichtungen 1, 2, 3, 4, 5, 6 sowie Haupt-Verbindungseinrichtungen 7A, 7B, 7C und Gruppen-Verbindungseinrichtungen 9A, 9B in Richtung des Pfeils VI in Fig. 5. In dieser Darstellung ist zu sehen, dass die unteren Steckverbinderanordnungen V_{U} im Grundriss deckungsgleich mit den oberen Steckverbinderanordnungen V_{O} angeordnet sind, so dass sich die Leiterplatten 10, 70A, 20, 90A, 30, 70B, 40, 90B, 50, 70C, 60 wie in Fig. 6 gezeigt aufeinander stecken lassen. In Fig. 6 ist auch die durch den Abstand L und den Vertikalabstand zwischen zwei Leiterplatten definierte Kühllufteintrittsöffnung beziehungsweise Kühlluftaustrittsöffnung L' zu erkennen. Des Weiteren ist zu erkennen, dass sowohl die oberste Leiterplatte 10 als auch die unterste Leiterplatte 60 mit freien oberen beziehungsweise unteren Steckverbinderanordnungen V_{O} beziehungsweise V_{U} versehen ist, in die noch weitere Einrichtungen, beispielsweise Erweiterungseinrichtungen, gesteckt werden können.

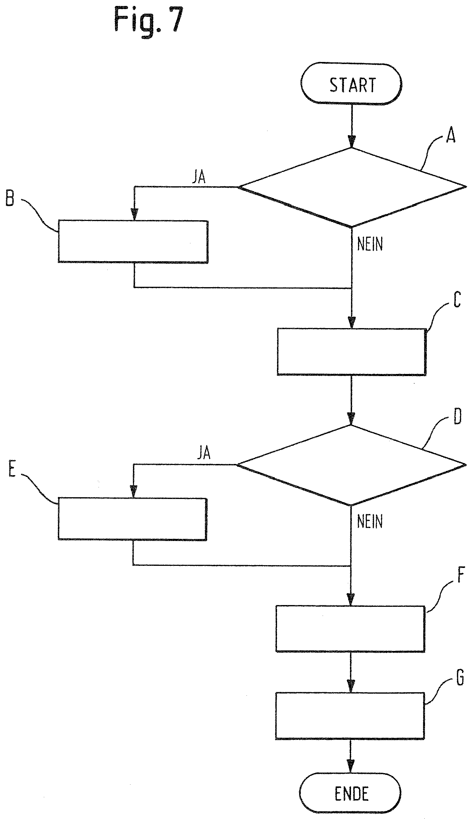

In Fig. 7 ist der Ablauf eines Computerprogramms zur flexiblen Verschaltung der Verbindungsstruktur einer erfindungsgemäßen Vorrichtung schematisch dargestellt.

Nach dem Start des Programms prüft das Computerprogramm in einem ersten Schritt A, ob es Elemente in dem zu emulierenden Entwurf eines integrierten Schaltkreises gibt, die eine Platzierungsvorgabe erfordern. Derartige Elemente sind beispielsweise programmierbare Logikschaltkreise oder Erweiterungsleiterplatten. Gibt es derartige Elemente, so werden diese Elemente in einem Schritt B vor allen anderen Elementen mit ihrer Platzierungsvorgabe platziert. Danach werden im Schritt C jene Elemente platziert, die keine Platzierungsvorgabe besitzen. Nachdem die Elemente alle platziert worden sind, wird im Schritt D überprüft, ob es Signale gibt, die ein festes Pinmapping, das heißt eine feste Belegung von Anschlusskontakten, erfordern. Derartige Signale mit festem Pinmapping können beispielsweise die Verbindungen von den programmierbaren Logikschaltkreisen zu den Erweiterungselementen sein. Gibt es derartige Signale, so werden diese im Schritt E mit Vorrang geroutet. Danach werden im Schritt F alle restlichen Signale geroutet. Unter Routen versteht man dabei das Zuordnen von Leitungswegen in der gesamten BUS-Verbindungsstruktur. Sind alle Signale geroutet worden, so werden im Schritt G die sogenannten Pinmappings an den programmierbaren Logikschaltkreisen berechnet, das heißt, dass berechnet wird, welcher Kontakt von welcher BUS-Leitung, der an einem Einbauplatz anliegt, mit welchen Anschluss der internen Struktur des programmierbaren Logikschaltkreises zu verbinden ist.

Ist dies erfolgt, so werden die einzelnen Schalter der jeweiligen BUS-Schaltvorrichtungen geschaltet und die interne Belegung der Anschlusskontakte der jeweiligen programmierbaren Logik-Schaltkreise wird entsprechend dem berechneten Pinmapping eingerichtet.

Die Erfindung ist nicht auf das obige Ausführungsbeispiel beschränkt, das lediglich der allgemeinen Erläuterung des Kerngedankens der Erfindung dient. Im Rahmen des Schutzumfangs kann die erfindungsgemäße Vorrichtung vielmehr auch andere als die oben beschriebenen Ausgestaltungsformen annehmen. Die Vorrichtung kann hierbei insbesondere Merkmale aufweisen, die eine Kombination aus den jeweiligen Einzelmerkmalen der Ansprüche darstellen.

Bezugszeichen in den Ansprüchen, der Beschreibung und den Zeichnungen dienen lediglich dem besseren Verständnis der Erfindung und sollen den Schutzumfang nicht einschränken.

## Patentansprüche

1. Vorrichtung zur Emulation von Entwürfen für integrierte Schaltkreise mit
zumindest einer Aufnahmeeinrichtung (1, 2, 3, 4, 5, 6) ausgebildet zur Aufnahme von einer Mehrzahl von programmierbaren Logikschaltkreisen (11, 12, 13; 21, 22, 23) mit Anschlusskontakten sowie einer elektrischen Verbindungsstruktur (14; 24), die BUS-Leitungen (111, 112, 121, 122, 131, 132; 211, 212, 221, 222, 231, 232) aufweist, die jeweils eine Vielzahl von Kanälen (1...k) umfassen,
wobei jeder programmierbare Logikschaltkreis (11, 12, 13; 21, 22, 23) der Mehrzahl von programmierbaren Logikschaltkreisen an zumindest eine BUS-Leitung der BUS-Leitungen (111, 112, 121, 122, 131, 132; 211, 212, 221, 222, 231, 232) angeschlossen ist, wenn er mit der Aufnahmeeinrichtung verbunden ist,
wobei die elektrische Verbindungsstruktur (14; 24) so ausgebildet ist, dass die Mehrzahl von programmierbaren Logikschaltkreisen unabhängig miteinander verbindbar sind,
wobei zumindest ein Teil der Anschlusskontakte eines jeden programmierbaren Logikschaltkreises (11, 12, 13; 21, 22, 23) unabhängig belegbar ist,
wobei zumindest ein Teil der mit den programmierbaren Logikschaltkreisen (11, 12, 13; 21, 22, 23) verbundenen BUS-Leitungen (111, 112, 121, 122, 131, 132; 211, 212, 221, 222, 231, 232) mittels eines Schalters (S₁...Sₖ) wahlweise miteinander elektrisch verbindbar ist,
wobei zumindest ein Kanal (1...k) einer BUS-Leitung (111, 112, 121, 122, 131, 132; 211,212, 221, 222, 231, 232) mit einem Kanal (1...k) von zumindest einer anderen BUS-Leitung (111, 112, 121, 122, 131, 132; 211, 212, 221, 222, 231, 232) mittels des Schalters (S₁...Sₖ) elektrisch verbindbar ist,
wobei mehrere Aufnahmeeinrichtungen (1, 2; 3, 4; 5, 6) vorgesehen und über Verbindungseinrichtungen (7A, 7B, 7C; 9A, 9B) miteinander verbindbar sind, wobei die Verbindungseinrichtungen (7A, 7B, 7C; 9A, 9B) schaltbare BUS-Leitungen aufweisen.

2. Vorrichtung nach Anspruch 1,
**dadurch gekennzeichnet,**
**dass** eine Mehrzahl von Kanälen (1...k) einer BUS-Leitung (111, 112, 121, 122, 131, 132; 211, 212, 221, 222, 231, 232) mit einer Mehrzahl von Kanälen (1...k) einer anderen BUS-Leitung (111, 112, 121, 122, 131, 132; 211, 212, 221, 222, 231, 232) wahlweise elektrisch verbindbar ist, wobei jeder Kanal (1...k) der einen BUS-Leitung (111, 112, 121, 122, 131, 132; 211, 212, 221, 222, 231, 232) mit dem Kanal (1...k) der anderen BUS-Leitung (111, 112, 121, 122, 131, 132; 211, 212, 221, 222, 231, 232) elektrisch verbindbar ist, wobei einzelne Kanäle der Mehrzahl von Kanälen (1...k) unabhängig voneinander verbindbar sind.

3. Vorrichtung nach Anspruch 1,
**dadurch gekennzeichnet,**
**dass** sie zwischen zumindest einem Teil der programmierbaren Logikschaltkreise (11, 12, 13; 21, 22, 23) Verbindungs-BUS-Leitungen (15, 16, 17; 25, 26, 27) zur direkten Verbindung von zumindest einem Teil der programmierbaren Logikschaltkreise (11, 12, 13; 21, 22, 23) miteinander aufweist.

4. Vorrichtung nach Anspruch 1,
**dadurch gekennzeichnet,**
**dass** sie weiterhin Haupt-Verbindungseinrichtungen (7A, 7B, 7C) aufweist, die jeweils zwei Aufnahmeeinrichtungen (1, 2; 3, 4; 5, 6) miteinander verbinden, wobei die Haupt-Verbindungseinrichtungen (7A, 7B, 7C) Hauptverbindungseinrichtungs-BUS-Leitungen (711, 712, 721, 722, 731, 732) aufweisen, die einander zugeordnete BUS-Leitungen (111, 112, 121, 122, 131, 132; 211, 212, 221, 222, 231, 232) der beiden Aufnahmeeinrichtungen (1, 2) miteinander verbinden und wobei die Hauptverbindungseinrichtungs-BUS-Leitungen (711, 712, 721, 722, 731, 732) derart wahlweise miteinander elektrisch verbindbar sind, dass zumindest ein Kanal (1...k) einer Hauptverbindungseinrichtungs-BUS-Leitung (711, 712, 721, 722, 731, 732) mit einem Kanal (1...k) von zumindest einer anderen Hauptverbindungseinrichtungs-BUS-Leitung (711, 712, 721, 722, 731, 732) elektrisch verbindbar ist.

5. Vorrichtung nach Anspruch 4,
**dadurch gekennzeichnet,**
**dass** sie weiterhin Gruppen-Verbindungseinrichtungen (9A, 9B) aufweist, die jeweils zwei Aufnahmeeinrichtungspaare miteinander verbinden, welche zwei mittels der Haupt-Verbindungseinrichtung (7A, 7B, 7C) miteinander verbundenen Aufnahmeeinrichtungen (1, 2; 3, 4; 5, 6) umfassen, und wobei eine Gruppen-Verbindungseinrichtung (9A; 9B) Gruppenverbindungseinrichtungs-BUS-Leitungen (911, 912, 913, 914, 915, 916) aufweist, die mit den BUS-Leitungen der Aufnahmeeinrichtungspaare (1, 2; 3, 4; 5, 6) verbunden sind und wobei die Gruppenverbindungseinrichtungs-BUS-Leitungen (911, 912, 913, 914, 915, 916) jeweils derart schaltbar sind, dass jedem Kanal (1...k) einer jeden Gruppenverbindungseinrichtungs-BUS-Leitung (911, 912, 913, 914, 915, 916) ein Schalter einer Mehrzahl von Schaltern (S₁ ... Sₖ) zugeordnet ist und wobei jeder Schalter der Mehrzahl von Schaltern so ausgebildet ist, dass er unabhängig von den anderen Schaltern der Mehrzahl von Schaltern ein- und ausschaltbar ist.

6. Vorrichtung nach Anspruch 5,
**dadurch gekennzeichnet,**
**dass** die Aufnahmeeinrichtungen (1, 2, 3, 4, 5, 6), die Haupt-Verbindungseinrichtungen (7A, 7B, 7C) und die Gruppen-Verbindungseinrichtungen (9A, 9B) Leiterplatten (10, 20, 30, 40, 50, 60; 70A, 70B, 70C; 90A, 90B) aufweisen, die an ihrer Oberseite und an ihrer Unterseite jeweils mit einer Steckverbinderanordnung (V_{O}, V_{U}) versehen sind, die mehrere Steckverbinder umfasst, welche in derselben Position auf den Leiterplatten (10, 20, 30, 40, 50, 60; 70A, 70B, 70C; 90A, 90B) angeordnet sind und wobei die nach außen führenden BUS-Leitungen der Leiterplatten (10, 20, 30, 40, 50, 60; 70A, 70B, 70C; 90A, 90B) sowohl mit oberen als auch mit entsprechenden unteren Steckverbindern der Steckverbinderanordnung (V_{O}, V_{U}) in gleicher Weise elektrisch verbunden sind.

7. Vorrichtung nach Anspruch 6,
**dadurch gekennzeichnet,**
**dass** die Leiterplatten (10, 20, 30, 40, 50, 60; 70A, 70B, 70C; 90A, 90B) übereinander angeordnet und mittels der Steckverbinderanordnungen (V_{O}, V_{U}) mechanisch und elektrisch miteinander verbunden sind,
wobei jeweils zwei Leiterplatten (10, 20; 30, 40; 50, 60) der Aufnahmeeinrichtungen (1, 2; 3, 4; 5, 6) mittels einer zwischen den beiden Leiterplatten der Aufnahmeeinrichtungen angeordneten Leiterplatte (70A, 70B, 70C) einer Haupt-Verbindungseinrichtung (7A, 7B, 7C) zu einem Aufnahmeeinrichtungspaar verbunden sind, um einen Aufnahmeeinrichtungs-Hauptverbindungsreinrichtungs-Leiterplattenstapel zu bilden,
wobei das Aufnahmeeinrichtungspaar eines von mehreren Aufnahmeeinrichtungspaaren ist, und
wobei die Aufnahmeeinrichtungspaare miteinander mittels der Leiterplatten (90A, 90B) der Gruppen-Verbindungseinrichtungen (9A, 9B) verbunden sind.

8. Vorrichtung nach Anspruch 7,
**dadurch gekennzeichnet,**
**dass** zwischen einigen der Steckverbinder der Steckverbinderanordnungen (V_{O}, V_{U}) ein Abstand (L) vorgesehen ist, der so dimensioniert ist, dass er das Durchströmen von Kühlluft zwischen den Steckverbindern durch den Leiterplattenstapel ermöglicht.

9. Vorrichtung nach Anspruch 1,
**dadurch gekennzeichnet,**
**dass** die Mehrzahl von programmierbaren Logikschaltkreisen FPGAs aufweist.
